# FASCICULE DE BREVET EUROPEEN

(11) **EP 0 755 572 B1**
(45) Date de publication et mention de la délivrance du brevet: **09.06.1999**
(21) Numéro de dépôt: 95918021.7
(22) Date de dépôt: 18.04.1995
(51) Int. Cl.: H01L 21/336, H01L 21/84, G02F 1/136

(54) **ECRAN A CRISTAUX LIQUIDES A MATRICE ACTIVE**
FLÜSSIGKRISTALL-BILDSCHIRM MIT AKTIVER MATRIX
LIQUID CRYSTAL SCREEN WITH AN ACTIVE MATRIX

(30) Priorité: 15.04.1994 FR 9404523
(43) Date de publication de la demande: 29.01.1997
(73) Titulaire: THOMSON-LCD, 75008 Paris (FR)
(72) Inventeur: LEBRUN, Hugues, F-38500 Coublevie (FR); SZYDLO, Nicolas, F-38000 Grenoble (FR); MAURICE, François, F-38210 Tullins-Fures (FR)
(74) Mandataire: Ruellan-Lemonnier, Brigitte
(86) Numéro de dépôt international: FR9500503
(87) Numéro de publication internationale: WO9528738

(56) Documents cités:
- EP-A- 0 211 401
- EP-A- 0 216 673
- EP-A- 0 530 834
- US-A- 4 705 358
- PATENT ABSTRACTS OF JAPAN vol. 010 no. 367 (E-462) ,9 Décembre 1986 & JP,A,61 164267 (NEC CORP) 24 Juillet 1986,
- PATENT ABSTRACTS OF JAPAN vol. 017 no. 566 (P-1629) ,14 Octobre 1993 & JP,A,05 165058 (CASIO COMPUT CO LTD) 29 Juin 1993,
- JAPANESE JOURNAL OF APPLIED PHYSICS, SUPPLEMENTS, pages 1197-1198, XP 000178204 AKIHISA YOSHIDA ET AL 'FABRICATION OF A-SI:H TFT'S BY A LARGE AREA ION DOPING TECHNIQUE'
- IEEE ELECTRON DEVICE LETTERS, JAN. 1994, USA, vol. 15, no. 1, ISSN 0741-3106, XP 000430418 SASAKI M ET AL 'The impact of oxidation of channel polysilicon on the trap-density of submicron bottom-gate TFT's'

## Description

La présente invention concerne une structure particulière d'écrans à cristaux liquides selon la revendication 1 comportant une matrice active comportant des transistors en couches minces permettant l'élimination de phénomènes parasites.

Les transistors en couches minces sont bien adaptés au commande des électrodes des pixels d'un écran à cristaux liquides. Ces derniers sont composés de lignes (lignes de sélection) et colonnes (lignes de données) aux intersections desquelles sont situées les électrodes de pixels connectées au travers des transistors à ces lignes. Les grilles de ces transistors forment des lignes de sélection et sont commandées par les circuits de commande périphériques qui balayent les lignes et rendent passants les transistors de chaque ligne en permettant, par les lignes de données connectées aux autres circuits de commande périphériques, de polariser les électrodes et moditier les propriétés optiques du cristal liquide compris entre ces électrodes et la contre-électrode (ou électrode de référence).

Les transistors sont de préférence à effet de champ à base de silicium amorphe et réalisés à partir d'un empilement de couches minces. Ils peuvent être dits étagés inverses dans la mesure où leurs grilles sont situées sous l'isolant de grille et sous le niveau semi-conducteur comme décrit dans la demande européenne EP-A-0211401. Ils sont donc utilisés comme dispositifs de commutation des écrans à cristaux liquides dits à matrice active. La présente invention concerne un design particulier d'un écran à cristaux liquides. Cet écran à cristaux liquides comporte une matrice active constituée d'électrodes de pixels commandées par des transistors en couches minces dont la partie sources et drains est constituée par les colonnes et les électrodes de pixels et les lignes de sélection par les lignes, et il est caractérisé en ce qu'un segment connecté par une de ses extrémités à la ligne est situé à un niveau différent des niveaux conducteurs colonne et électrode de pixel et les croise dans cet ordre afin de réaliser l'electrode de grille du transistor de façon à ce que le transistor parasite soit situé entre deux colonnes adjacentes et non entre une colonne adjacente et l'électrode de pixel. Ainsi, la gravure du niveau de grille est faite de manière à ce que le segment de métal de grille réalisant le transistor, dont la source et le drain sont respectivement la colonne et le pixel, soit à un endroit différent de la ligne de sélection. Cela permet d'éliminer le transistor parasite entre l'électrode de pixel et la colonne adjacente.

Le brevet EP-A-0 216 673 décrit aussi un écran à cristaux liquides permettant une diminution de phénomènes parasites.

La présente invention sera mieux comprise et des avantages supplémentaires apparaîtront à la lecture de la description qui va suivre illustrée par les figures suivantes :
- la figure 1 représente une vue planaire d'un motif d'une matrice active réalisée selon l'art antérieur
- et la figure 2 représente un perfectionnement de ce même motif selon la présente invention.

Dans le cas d'un procédé de fabrication de transistors étagés inverses à trois étapes de photolithographie, les étapes du procédé de fabrication peuvent être les suivantes :
- la première étape consiste à déposer et à graver le métal de grille (première étape de photolithographie),
- la seconde, à déposer la tricouche isolant de grille, silicium amorphe et silicium amorphe dopé, puis à graver les couches silicium intrinsèque et silicium dopé. Cette étape consiste à déposer une résine positive sur la tricouche, l'insoler en face arrière au travers du substrat en utilisant comme masque les motifs définis au niveau grille, développer la résine positive, graver la bicouche, puis éliminer le restant de résine (seconde étape de photolithographie),
- la troisième à déposer et graver l'électrode de pixel-drain et colonne-source en ITO (ou tout autre type de conducteur transparent) (troisième étape de photolithographie),
- et la quatrième à oxyder selon l'invention le silicium amorphe dopé n+ de la même manière que décrit plus haut afin d'isoler les contacts de source et de drain.

En effet, la technologie utilisant la gravure pour isoler les contacts de source et de drain ne peut être appliquée dans ce cas. Pour éviter que le silicium intrinsèque ne soit totalement gravé, il faut en déposer une épaisseur importante. Or, l'insolation n'est pas possible au travers d'un silicium intrinsèque trop épais.

La quatrième étape autorise l'utilisation de faibles épaisseurs de silicium (typiquement inférieures à 500 Å) et donc quasiment transparent à la longueur d'onde d'insolation de la résine.

D'autre part, avec une surgravure astucieuse de la résine, on peut reproduire une technologie de masque noir.

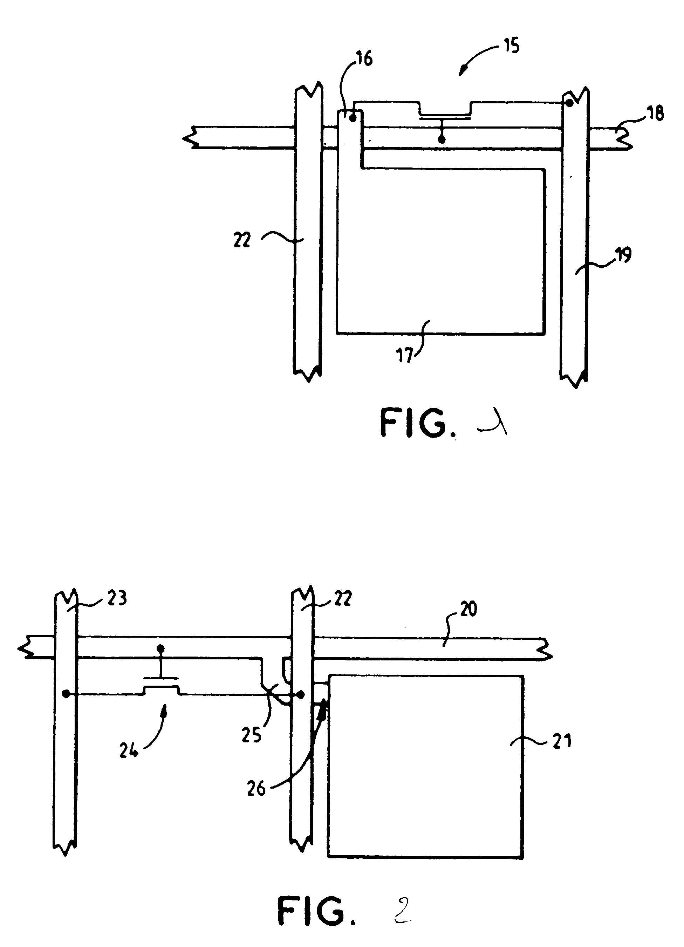

Cependant, comme cela est représenté sur la figure 1, l'utilisation de cette technologie à 3 étapes de photolithographie pose le problème de la présence de transistors parasites. En effet, la ligne 18 horizontale constitue les grilles des transistors de commande des pixels de la ligne de l'écran représenté sur cette figure, la colonne 22 et le doigt 16 de l'électrode de pixel 17 constituant les source et drain de ce transistor. On constate qu'il existe un transistor parasite 15 qui a pour grille la ligne 18 et pour source et drain le doigt 16 de l'électrode de pixel 17 et la colonne adjacente 19, la ligne étant une superposition de couches métal / isolant de grille / silicium amorphe intrinsèque.

Un perfectionnement de la présente invention consiste à utiliser une structure judicieuse de transistor de commande de pixel permettant d'éliminer dans ce procédé de réalisation de transistors étagés inverses, ces transistors parasites.

Un exemple de réalisation de ce type de transistor de commande de pixel est représenté sur la figure 2. Lors de la première étape du procédé permettant de réaliser un transistor étagé inverse avec trois étapes de photolithographie, chaque ligne 20 est gravée de manière à ce qu'un segment 25 - de préférence en forme de "L" majuscule - solidaire par une de ses extrémités de la ligne 20, vienne, parallèlement à celle-ci, jusque dans la zone où sera déposée et gravée l'électrode de pixel en passant sous la zone où sera déposée et gravée dans la même étape du procédé que le pixel (ou au cours d'une étape différente) la colonne 22. Le niveau de grille est situé entre la plaque-substrat éventuellement munie d'une grille noire ("Black Matrix"), et le ou les niveaux conducteurs colonne et électrode de pixel. Ainsi est créé un transistor 26 étagé inverse, le segment 25 constituant la grille, la colonne 22 et l'électrode 21 constituant les source et drain. Le transistor parasite 24 relie deux colonnes adjacentes (colonnes qui transportent des informations qui ne sont pas destinées au pixel) et le pixel 21 est isolé de la colonne adjacente de la figure 1. Le problème du transistor de la figure 1 est éliminé.

Par ailleurs, cette structure de transistor de commande de pixel proposé ici, est aussi applicable à la réalisation d'un transistor de commande étagé direct, c'est-à-dire à "grille dessus". Dans ce cas, la grille constituée par le segment connecté par une de ses extrémités à une ligne, est déposée après les source et drain (colonne et électrode de pixel) qui peuvent être réalisés ensemble dans un même matériau ou indépendamment dans des matériaux différents et le niveau semi-conducteur. Un exemple de ce type de technologie dite "grille dessus" qui ne peut ne nécessiter que deux ou trois niveaux de masquage est décrite dans le brevet EP 0 103 523 du CNET.

La présente invention s'applique à tous les types de transistors en couches minces à effet de champ étagés inverses, comme par exemple ceux utilisés dans les barrettes de photodiode et particulièrement à ceux utilisés pour la réalisation de matrice active d'écrans à cristaux liquides commandés par des circuits électroniques périphériques externes et / ou intégrés (drivers intégrés) sur la plaque substrat de la matrice active.

## Revendications

1. Ecran à cristaux liquides comportant une matrice active constituée d'électrodes de pixels commandées par des transistors (26) en couches minces dont la partie sources et drains est consistuée par les conducteurs colonnes (22) et les électrodes (21) de pixels et les lignes de sélection par les lignes (20), caractérisé en ce qu'un segment (25) connecté par une de ses extrémités à la ligne (20) est situé à un niveau différent des niveaux conducteurs colonne (22) et électrode de pixel (21) et les croise dans cet ordre afin de réaliser l'électrode de grille du transistor (26) de façon à ce que le transistor parasite (24) soit situé entre deux colonnes adjacentes et non entre une colonne adjacente et l'électrode de pixel.

2. Ecran selon la revendication 1, caractérisé en ce que le segment (25) formant la grille du transistor (26) est situé entre la plaque substrat sur laquelle est réalisée la matrice active, et le conducteur colonne (22) et l'électrode de pixel (21).

3. Ecran selon la revendication 1, caractérisé en ce que le segment (25) formant la grille du transistor (26) est situé sur le conducteur colonne (22) et l'électrode de pixel (21), eux-mêmes déposés sur la plaque substrat sur laquelle est réalisée la matrice active.

4. Ecran à cristaux liquides selon l'une quelconque des revendications précédentes, caractérisé en ce qu'il comporte des circuits électroniques périphériques de commandes intégrées sur la même plaque substrat.

## Claims

1. Liquid-crystal screen comprising an active matrix consisting of pixel electrodes driven by thin-film transistors (26), the source and drain parts of which make up the column conductors (22) and the pixel electrodes (21) and the selection lines make up the rows (20) characterized in that a segment (25) connected by one of its ends to the row (20) lies at a different level from the column-conductor (22) and pixel-electrode (21) levels and it crosses them in this order so as to produce the gate electrode of the transistor (26) so that the parasitic transistor (24) lies between two adjacent columns and not between an adjacent column and the pixel electrode.

2. Screen according to Claim 1, characterized in that the segment (25) forming the gate of the transistor (26) lies between the substrate panel, on which the active matrix is produced, and the column conductor (22) and the pixel electrode (21).

3. Screen according to Claim 1, characterized in that, the segment (25) forming the gate of the transistor (26) lies on the column conductor (22) and the pixel electrode (21), the latter themselves being deposited on the substrate panel on which the active matrix is produced.

4. Liquid-crystal screen according to any one of the preceding claims, characterized in that it comprises integrated peripheral electronic drive circuits on the same substrate panel.

## Patentansprüche

1. Flüssigkristall-Bildschirm mit einer aktiven Matrix aus Pixelelektroden, die durch Dünnschicht-Transistoren (26) gesteuert werden, deren Source- und Drainbereich durch Spaltenleiter (22) und deren Pixelelektroden (21) und Auswahlzeilen durch die Zeilen (20) gebildet werden,
dadurch gekennzeichnet, daß ein Segment (25), das mit einem seiner Enden mit der Zeile (20) verbunden ist, bei einem Niveau liegt, das von den Niveaus der Spaltenleiter (22) abweicht und diese in dieser Reihenfolge kreuzt, um dadurch die Gitterelektrode des Transistors (26) derart auszubilden, daß der parasitäre Transistor (24) zwischen zwei benachbarten Spalten und nicht zwischen einer benachbarten Spalte und der Pixelelektrode liegt.

2. Bildschirm nach Anspruch 1,
dadurch gekennzeichnet, daß das das Gitter des Transistors (26) bildende Segment (25) zwischen dem Substrat, auf dem die aktive Matrix ausgebildet ist, und dem Spaltenleiter (22) der Pixelelektrode (21) liegt.

3. Bildschirm nach Anspruch 1,
dadurch gekennzeichnet, daß das das Gitter des Transistors (26) bildende Segment (25) auf dem Spaltenleiter (22) und der Pixelelektrode (21) liegt, die selbst auf das Substrat aufgebracht sind, auf der die aktive Matrix ausgebildet ist.

4. Flüssigkristall-Bildschirm nach einem der vorangehenden Ansprüche,
dadurch gekennzeichnet, daß der Bildschirm elektronische periphere Steuerschaltungen enthält, die auf demselben Substrat integriert sind.
